Europäisches Patentamt

(19) European Patent Office

Office européen des brevets

(11) Publication number: **0 252 029**
**A2**

(12) # EUROPEAN PATENT APPLICATION

(21) Application number: **87830241.3**

(22) Date of filing: **26.06.87**

(51) Int. Cl.⁴: **G 03 B 41/00**
**G 03 F 9/00**

(30) Priority: **30.06.86 IT 4820586**

(43) Date of publication of application:
**07.01.88 Bulletin 88/01**

(84) Designated Contracting States: **DE FR GB NL SE**

(71) Applicant: **SELENIA INDUSTRIE ELETTRONICHE ASSOCIATE S.p.A.**
**Via Tiburtina, KM 12.400**
**I-00131 Roma (IT)**

(72) Inventor: **Antonio, Cetronio**
**Via di Villa Taverna, 20**
**I-00400 Monte Porzio (IT)**

**Di Bona, Maurizio**
**Corso M. Equicola, 70**
**I-03041 Alvito Frosinone (IT)**

**The other inventor has agreed to waive his entitlement to designation**

(74) Representative: **Emiliani, Gabriele, Ing.**
**c/o ITALPATENT Via Agri, 3**
**I-00198 Roma (IT)**

(54) **Technique for the alignment through conventional photolithography of a structure on the back of a sample with high recording accuracy.**

(57) Technique which utilizes conventional photolithography for high recording alignment accuracy of a given structure on the back of a sample using the machined front of the sample as a reference.

Such technique may be applied to any type of substrate, such as Silicon, Germanium, composite semicontuctors, quartz, glass, metal etc.

The technique does not call for any particular equipment and, furthermore, it is independent of the type and thickness of the substrate adopted.

FIG. 1

## Description

"TECHNIQUE FOR THE ALIGNMENT THROUGH CONVENTIONAL PHOTOLITHOGRAPHY OF A STRUCTURE ON THE BACK OF A SAMPLE WITH HIGH RECORDING ACCURACY"

The invention takes regard for a technique through which a structure may be aligned with great recording accuracy on the rear of a sample, using conventional photolithography.

For those devices using volume (2) characteristics of the material, at times there is a need to align, on the back of sample (3), structures (4) of great recording accuracy, with the corresponding work performed on the front (1).Such technique, through adoption of conventional photolithography, gives way to structures of the type shownm with an alignment tolerance between front and rear,of ± 1 μm.

In particular, the technique covered by the invention presented herein, is based upon the use of a suitable stencil which is used,as well as in conventional terms, also as a support for the substrate of interest, that is to say, the same template provides for alignment and bonding of the substrate onto the support and also provides for the alignment of any support on the rear of the substrate itself through its own visible references on the exterior of the latter.

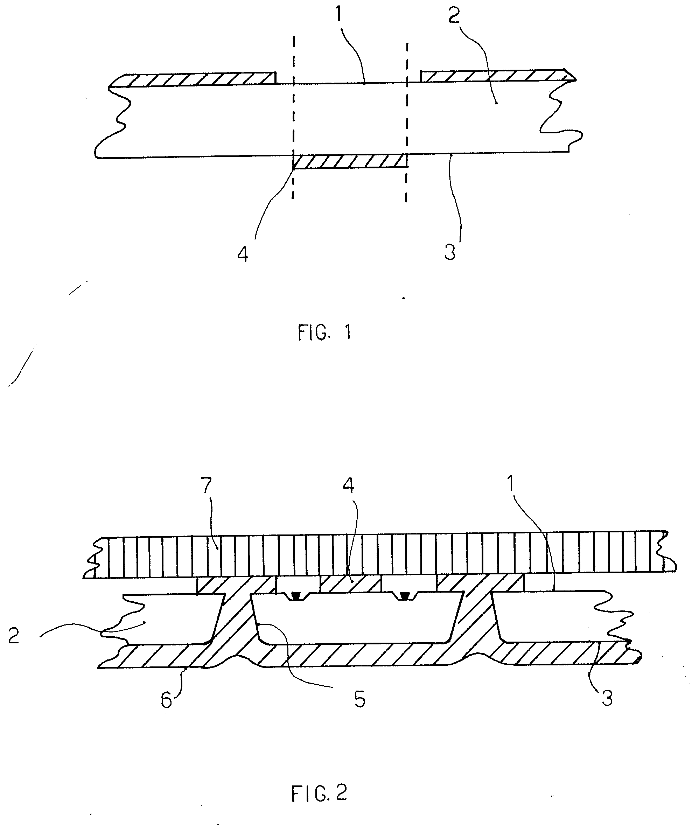

One of the various ways in which the invention's innovative process may be implemented is described, in particular to obtain,via holes on Ga As strata to ground, as shown in Figure 2, sources (4) of power MESFETS through the thickness of the material (2).

The invention will now be described with non limiting illustrative purpose, with reference to the figures enclosed:

Figure 1 shows the section of an hypothetical structure, built on the front and rear of a substrate in which :
(1) sample front;
(2) sample;
(3) sample rear;
(4) structure (or tooling) on the sample surfaces;

Figure 2 shows the shematic outline of the via - holes aligned under the source pads of a power MESFET, in which:
(5) via holes;
(6) metal layer;
(7) stencil;

Figure 3a shows the tooled front surface of the sample.

Figure 3b shows the surface of the stencil onto which the sample is bonded, where
(8) is a rectangular structure on the sample carrier template;
(9) is a square structure on the sample carrier template;
(10) is the template to align the structure on the sample rear.

Figure 3c is the surface of the template to obtain the structure on the sample rear.

Figure 4 shows two of the implementation phases during structure alignment on the rear of the sample;
a) template-sample-template assembly ready for alignment of the structure on the rear.

In short, the salient features of this process are the following:
a) production of the MESFET on the front (1) of GaAs substrate (2);
b) bonding of substrate (2) on a suitable sample carrier (7);
c) milling of GaAs substrate (2) to reduce it to the required thrickness;
d) alignment of the via holes (5) template on the rear (3) of the substrate correspondingly to the source pads (4);
e) erosion of GaAs to produce via holes (4);
f) metal coating (6) of the rear (3) to ground sources (4) of the MESFET through the volume material of substrate (2).

The innovative phases of this invention are, essentially,those under b) and d). In fact, as the thinning of the substrate is essential for power MESFET to achieve good thermal impedance of the device, in this application the technique presented has the advantage of not introducing further technological steps to the process. However the great advantage of this technique is that it does not require particular equipment (a conventional aligner is all that is required) and as such it disposes of the need for costly infrared systems. These in fact work on the principle that many semiconductors are transparent to infrared wavelengths, so that it is possible to see through the material during alignment on the rear. Obviously, compared to infrared systems, the technique proposed has the further advantege of being applicable to any type of substrate and, up to a certain extent, this can take place indipendently of the substrate thickness.

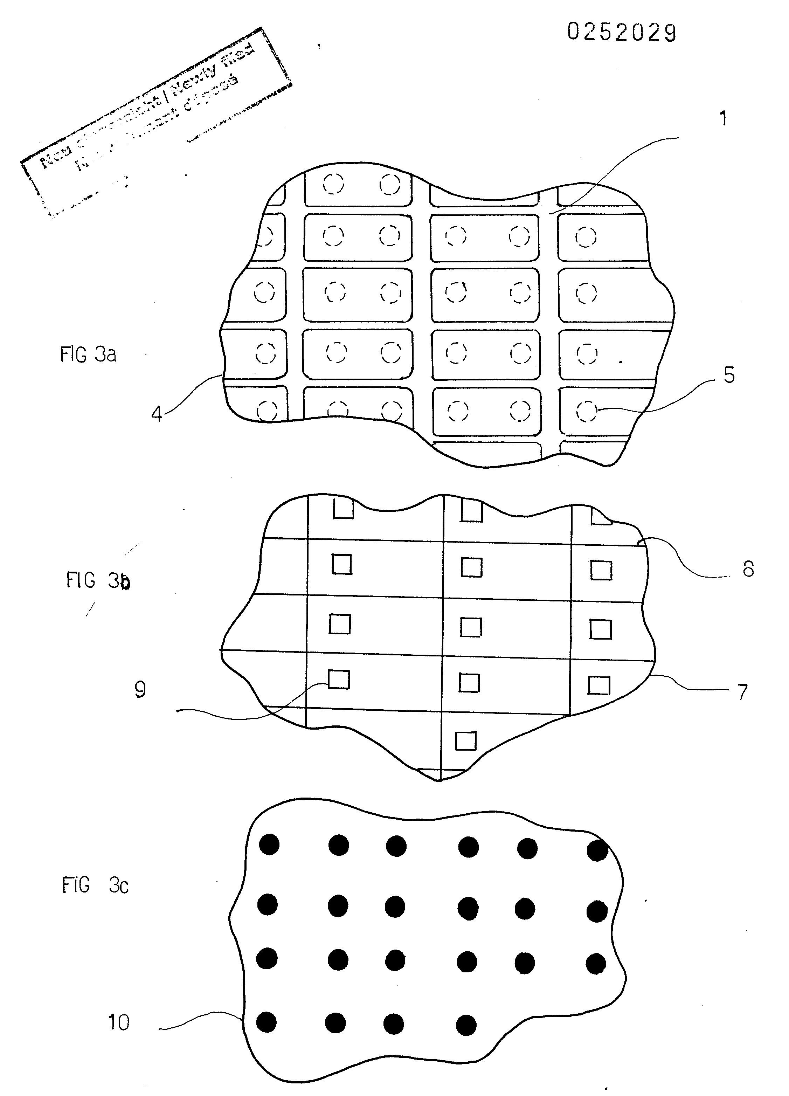

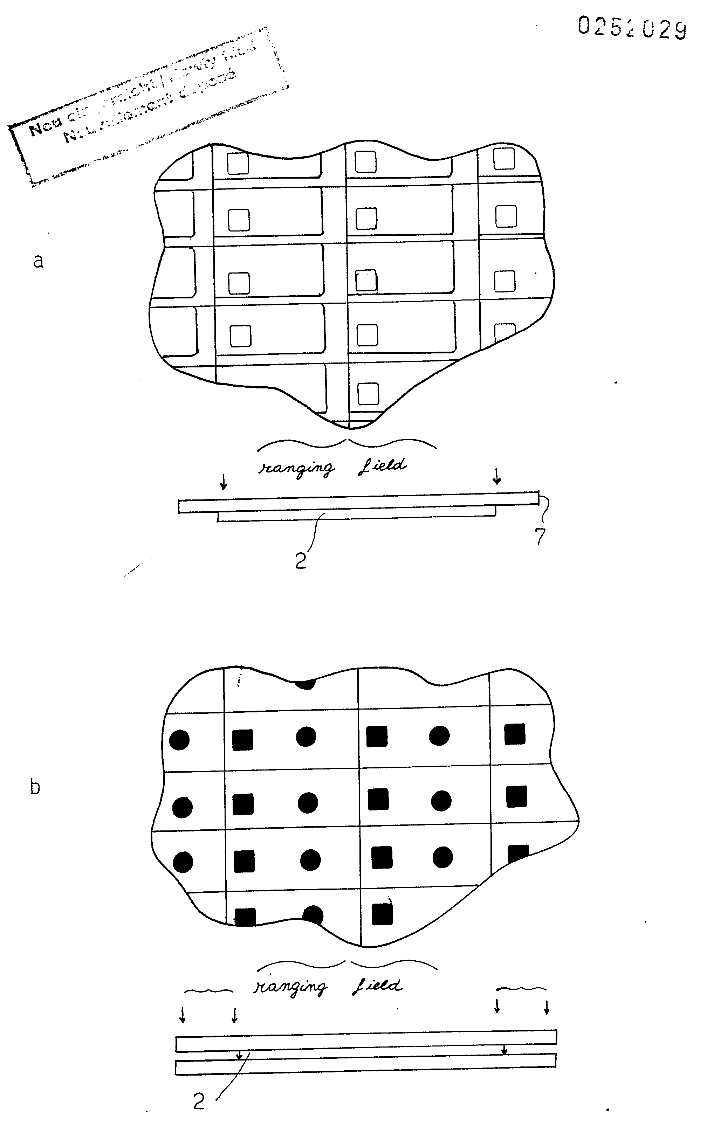

The details of the different production phases required to align via holes (5) on the rear (3) of a GaAs substrate correspondingly to source (4) of MESFET devices on the front (1), as already shown in Figure 2, will now be presented with reference to the schematic illustrations presented in figures 3 and 4.

To achieve the following alignment (Figure 3a) through conventional photolythography, one must generate a template supplementary to those otherwise required by IR. Such template (7), which later serves also a sample carrier during milling (Figure 3b), includes two basic references: one rectangular structure (8) capable of framing device source (4) perfectly and a square structure (9), with the via hole pitch; clearly for the latter, a suitable template (10) is required, as shown in figure 3c.

As mentioned above, the first phase of the process is that of producing, on the front (1) of GaAs substrate (2) the device of interest, such as a power MESFET; then to align via holes (5) on the rear (3) of the device, correspondingly to source pads (4), the following steps are taken:

g) spread a high viscosity resist on the crome plated surface of template (7), which contains the references of the device and of the via holes (fig. 3b);

h) spread a medium viscosity resist on the front (1) of GaAs substrate (2) equipped with MESFET devices;

i) align with the aid of a conventional aligner, template (7) with substrate (2) so that the edges of the devices fit the rectangular structure (8) on template (7) perfectly as shown in Figure 4a;

l) once aligned, put template (7) and substrate (2) into hard contact for about 30 seconds: this exploits the bonding characteristics of the unbaked resist to bond template (7) to substrate (2);

m) bake the assembly at 90°C for preferably one hour to stabilize bonding. At this stage, if required, the substrate may be thinned through suitable GaAs milling using template (7) sample carrier for the miller empty chuck; if thinning of the substrate isn't required, the via holes are next aligned;

n) with template (7) acting as carrier of assembly (2), (7) previously aligned, spread a medium viscosity resist on the rear (3) of substrate (2);

o) bake the assembly at 90°C for about 30 minutes;

p) align through template (10) the via holes an the rear (3) of substrate (2) using the areas external to the substrate (2) as guidelines;

q) having performed the alignment as shown in Figure 4b, expose the resist for a predetermined time, of the order of a few seconds and develop the areas exposed.

As now the via holes have been aligned, the next steps serve only to complete the process;

r) deposit a Ni film (2000°A thick) through lift off, as template of the following etches;

s) erode the GaAs with reactive Plasma to define the via holes;

t) evaporate a Ni/Cr: Au (300    2000°A) film;

u) deposit through galvanic technique a 5µ thick gold film (6)

v) peel off substrate (2) from template (7) by wetting with hot acetone.

The main characteristics of the invention may be summarized in the fact that such technique, which uses conventional photolithography to align, with high recording accuracy, a predetermined structure on the rear of a sample, takes as reference the device produced on its front.

This technique uses a suitable template onto which the substrate of interest is aligned and bonded; such template is later also used as reference to align a predetermined structure on the rear of the substrate. In fact, as shown with the example given, through this technique via holes can be aligned on the rear of a GaAs substrate, in perfect correspondence with the source of power MESFET devices.

Compared to commercially available systems which utilise an IR detector and source to see through the substrate, this technique does not require any peculiar equipment and furthermore, it is applicable to any type of substrate, such as Silicon, Germanium, composite semiconductors, quartz, glass, metal etc.

## Claims

1. Technique to align through conventional photolithography, a structure on the rear of a sample, characterised by the fact that such structure to be built on the rear is achieved without making recourse to IR aligner:

a) spreading a preferably high viscosity resist on the crome plated face of template (7) with aligning references of the structure to be produced;

b) then spreading a further resist, preferably of medium viscosity on the front (1) of substrate (2) of the sample already bearing a finished product;

c) aligning with a conventional aligner, sample (2) with template (7);

d) pressing together sample (2) and template (7) for the time required for the sample to adhere to the template itself exploiting the bonding characteristics of the resist before baking;

e) baking of the assembly ( sample (2) and template (7)) preferably at 90°C and preferably for about one hour till the bonding has stabilised.

2. Technique to align through conventional photolithography a structure on the rear a sample, as per claim 1, characterized by the fact that with the template used as carrier of assembly (2 and 7) previously aligned and bonded,

f) a medium viscosity photopolymer is spread on the rear of sample (3);

g) the assembly is baked, preferably at 90°C and preferably for 30 minutes;

h) the sample is aligned with the template to be produced (10) using the border of the sample (2) as reference;

i) the resist is then exposed for a suitable time, proceeding then with the development of the areas exposed;

l) having achieved the resist structure, the production of the desidered structure through metal deposition is commenced.

3) Technique for alignment through conventional photolithography, as per claim 1 and 2, characterized by the fact that such technique makes possible further operations such as thinning of the substrate through milling and making of holes in the substrate itself.

4. Technique to align through conventional photolithography, as per claims above, characterized by the fact that the template serves the purpose of sample carrier and is furthermore capable of reutilization to carry out other similar operations.

5) Technique for conventional photolithography alignment as per claims above, characterized by the fact that such technique may be adopted for any type of substrate, such as semiconductors, glass, metal etc.

0252029

FIG. 1

FIG. 2

1

FIG 3a

4

5

FIG 3b

9

6

7

FIG 3c

10

0252029

a

*ranging field*

2

7

b

*ranging field*

2